(19)

Europäisches
Patentamt

European
Patent Office

Office européen
des brevets

(11) **EP 4 546 046 A2**

(12) **EUROPEAN PATENT APPLICATION**

(43) Date of publication:
**30.04.2025 Bulletin 2025/18**

(21) Application number: **24206625.6**

(22) Date of filing: **15.10.2024**

(51) International Patent Classification (IPC):
**G03F 1/24** *(2012.01)*     **G03F 1/48** *(2012.01)*
**G03F 1/54** *(2012.01)*

(52) Cooperative Patent Classification (CPC):
**G03F 1/24; G03F 1/48; G03F 1/54**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.10.2023 JP 2023184787**

(71) Applicant: **SHIN-ETSU CHEMICAL CO., LTD.
Tokyo 1000005 (JP)**

(72) Inventors:
• **KOSAKA, Takuro**
  **Niigata, 942-8601 (JP)**
• **INAZUKI, Yukio**
  **Niigata, 942-8601 (JP)**
• **OGOSE, Taiga**
  **Niigata, 942-8601 (JP)**

(74) Representative: **Hindles Limited
Clarence House
131-135 George Street
Edinburgh, EH2 4JS (GB)**

(54) **REFLECTIVE PHOTOMASK BLANK AND METHOD FOR MANUFACTURING REFLECTIVE PHOTOMASK**

(57)     A reflective photomask blank has: a substrate 10; a reflective multilayer film 20 that is formed on one main surface of the substrate 10 and reflects the exposure light; a protective film 50 formed in contact with the reflective multilayer film 20; and an absorbing film 70 that is formed on the protective film 50 and absorbs the exposure light. The protective film 50 is formed using a film containing ruthenium (Ru). The absorbing film 70 is formed using a single-layer film containing tantalum (Ta) and nitrogen (N), and has a content of nitrogen of 30 atom% or more and less than 60 atom%. Contrast between light reflected from a surface of the protective film 50 and light reflected on a surface of the absorbing film 70 with respect to light having a wavelength of 193 nm to 248 nm is 20% or more.

FIG. 1

EP 4 546 046 A2

**Description**

Technical Field

The present invention relates to a reflective photomask blank which is a material of a reflective photomask used for manufacturing a semiconductor device such as an LSI and a method for manufacturing a reflective photomask from the reflective photomask blank.

Background Art

In the process of manufacturing a semiconductor device, a photolithography technique of irradiating a transfer mask with exposure light and transferring a circuit pattern formed on the mask onto a semiconductor substrate (semiconductor wafer) through a reduction projection optical system is repeatedly used. Conventionally, a mainstream wavelength of the exposure light is 193 nm by argon fluoride (ArF) excimer laser light, and a pattern with dimensions smaller than the exposure wavelength has been finally formed by adopting a process called multi-patterning in which an exposure process and a processing process are combined a plurality of times.

However, since it has been necessary to form finer patterns due to continuous miniaturization of device patterns, an extreme ultraviolet (hereinafter referred to as EUV) lithography technique using EUV light having a wavelength shorter than that of ArF excimer laser light as exposure light has been used. The EUV light is light having a wavelength of about 0.2 nm to 100 nm, more specifically, light having a wavelength of around 13.5 nm. Since the EUV light has extremely low transmittance to a substance so that a conventional transmission type projection optical system or mask cannot be used, a reflective optical element is used. Therefore, a reflective photomask is also used as a mask for pattern transfer.

The reflective photomask is configured such that a multilayer reflective film that reflects EUV light is provided on a substrate and a pattern of an absorbing film that absorbs EUV light is formed on the multilayer reflective film. Meanwhile, a state before pattering of the absorbing film (including a state in which a resist film has been formed) is referred to as a reflective photomask blank, and this is used as a material of the reflective photomask. The reflective photomask blank generally has a basic structure including a low thermal expansion substrate, a multilayer reflective film that is formed on one of two main surfaces of the substrate and reflects EUV light, and an absorbing film that is formed thereon and absorbs EUV light.

As the multilayer reflective film, a multilayer reflective film that obtains a necessary reflectance with respect to EUV light by alternately laminating a molybdenum (Mo) layer and a silicon (Si) layer is usually used. Meanwhile, as the absorbing film, tantalum (Ta) or the like having a relatively large value of an extinction coefficient with respect to EUV light is used (JP 2002-246299 A).

Furthermore, as a protective film (capping film) for protecting the multilayer reflective film, a ruthenium (Ru) film as disclosed in JP 2002-122981 A is formed on the multilayer reflective film. In addition, in some cases, an etching mask film including chromium (Cr) is also formed on the absorbing film as an etching mask for forming the pattern on the absorbing film. On the other hand, a back surface conductive film is formed on the other main surface of the substrate. As the back surface conductive film, a metal nitride film has been proposed for electrostatic chucking, and examples thereof include films mainly containing chromium (Cr) and tantalum (Ta).

SUMMARY OF INVENTION

PROBLEM TO BE SOLVED BY INVENTION

The reflective photomask can be used as a mask for lithography by forming the pattern on the absorbing film such that EUV light is absorbed in a certain portion of an absorber pattern and EUV light is reflected from the other portion in which the protective film is exposed.

After the pattern is formed on the absorbing film, whether or not the absorber pattern is formed as designed is inspected. As light used for the inspection at this time, light having a wavelength of about 190 nm to 260 nm is applied to the mask to inspect a pattern of a reflected image of the light.

For this reason, contrast between light reflected from the absorbing film and light reflected from the portion where the absorbing film is removed and the protective film is exposed with respect to the inspection light is important in the inspection of the pattern of the absorbing film.

In order to increase the contrast, it is effective to form an oxide layer as a reflectance reduction layer on a surface layer of the absorbing film, and a reflectance with respect to the inspection light is reduced by forming a film in which the content of oxygen is intentionally increased, and the contrast in the reflectance can be increased. However, in a case where the film including a large amount of oxygen is formed on the surface layer, an etching rate of an oxide film in etching during processing is slower than that of a layer not including oxygen on the substrate side of the reflectance reduction layer of the absorbing film, and there is a problem that a sectional shape of the formed pattern is easily deteriorated.

An object of the present invention is to provide a reflective photomask blank with which a reflective photomask having a high contrast and having a good sectional shape of an absorbing film can be manufactured, and a method for manufacturing a reflective photomask using the reflective photomask blank.

MEANS FOR SOLVING PROBLEM

The present invention has been made to solve the above problem, and it has been found that, in an EUV mask blank in which a multilayer reflective film, a protective film including Ru, and an absorbing film containing Ta and N are sequentially formed on a substrate, when the absorbing film is a single-layer film containing 30 atm% or more of nitrogen, a sectional shape of a formed pattern is good with reflectance contrast of pattern inspection light maintained at 20% or more, whereby the present invention has been completed.

Therefore, the present invention provides the reflective photomask blank and the method for manufacturing a reflective photomask as below.

A reflective photomask blank according to the present invention may be a reflective photomask blank to be used as a material of a reflective photomask used in EUV lithography using EUV light as exposure light, the reflective photomask blank comprise:

a substrate;
a reflective multilayer film that is formed on one main surface of the substrate and reflects the exposure light;
a protective film formed in contact with the reflective multilayer film; and
an absorbing film that is formed on the protective film and absorbs the exposure light,
wherein the protective film is formed using a film containing ruthenium (Ru),
wherein the absorbing film is formed using a single-layer film containing tantalum (Ta) and nitrogen (N), and has a content of nitrogen of 30 atom% or more and less than 60 atom%, and
wherein contrast between light reflected from a surface of the protective film and light reflected on a surface of the absorbing film with respect to light having a wavelength of 193 nm to 248 nm is 20% or more.

In the reflective photomask blank according to the present invention,
a thickness of the absorbing film may be between 50 nm and 80 nm.

In the reflective photomask blank according to the present invention,
the protective film may be made of ruthenium (Ru) or ruthenium (Ru) and niobium (Nb).

In the reflective photomask blank according to the present invention,
a thickness of the protective film may be between 2 nm and 5 nm.

The reflective photomask blank according to the present invention may further comprise an etching mask film containing Cr used as an etching mask when the absorbing film is processed.

A method for manufacturing the reflective photomask blank according to the present invention by using a sputtering method.

In the method for manufacturing the reflective photomask blank according to the present invention,

an oxide layer with a thickness of 2 nm or less may be formed by exposure to air or by a heat treatment at 150°C or less in air after the absorbing film is formed on a side surface separated from the substrate.

In the method for manufacturing the reflective photomask blank according to the present invention,

the protective film may be made of ruthenium (Ru) or ruthenium (Ru) and niobium (Nb), and
a heat treatment may be performed at 150°C or lower in air after forming the protective film.

EFFECT OF INVENTION

According to the present invention, a reflective photomask blank with which a reflective photomask having a high contrast and having a good sectional shape of an absorbing film can be manufactured, and a method for manufacturing a reflective photomask using the reflective photomask blank are provided.

BRIEF DESCRIPTION OF DRAWINGS

FIG. 1 is a longitudinal sectional view illustrating an example of a reflective photomask blank according to an embodiment of the present invention;

FIG. 2 is a longitudinal sectional view illustrating an aspect in which a pattern of an absorbing film is formed in the reflective photomask blank according to the embodiment of the present invention;

FIG. 3 is a longitudinal sectional view illustrating an aspect in which an etching mask film is provided in the reflective photomask blank according to the embodiment of the present invention;

FIG. 4 is a longitudinal sectional view illustrating an aspect in which the etching mask film and a resist film are provided in the reflective photomask blank according to the embodiment of the present invention; and

FIG. 5 is a longitudinal sectional view illustrating an aspect in which a pattern of the etching mask film is formed using a resist pattern as an etching mask in the reflective photomask blank according to the embodiment of the present invention.

DETAILED DESCRIPTION

Hereinafter, an embodiment of the present invention will be described in more detail.

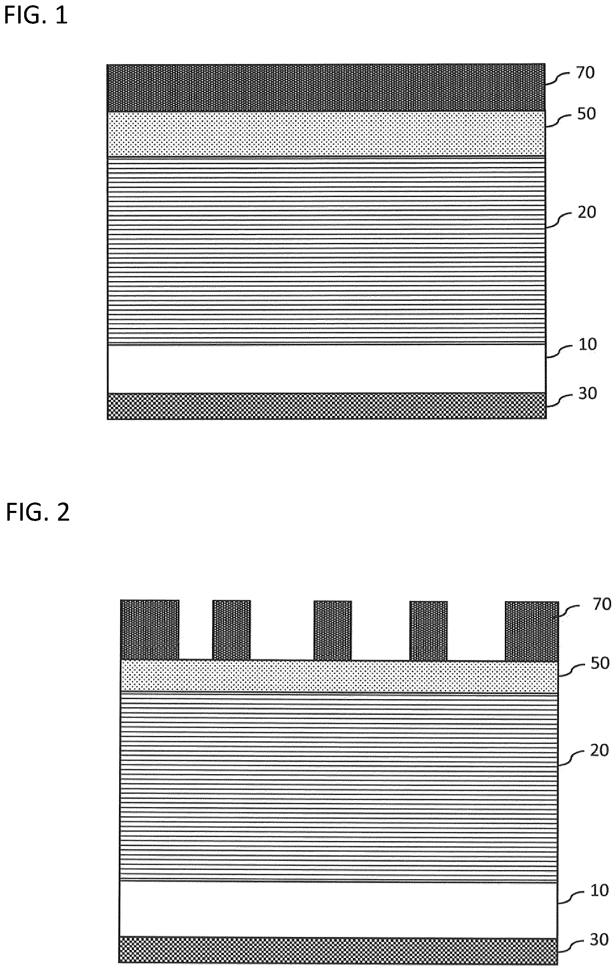

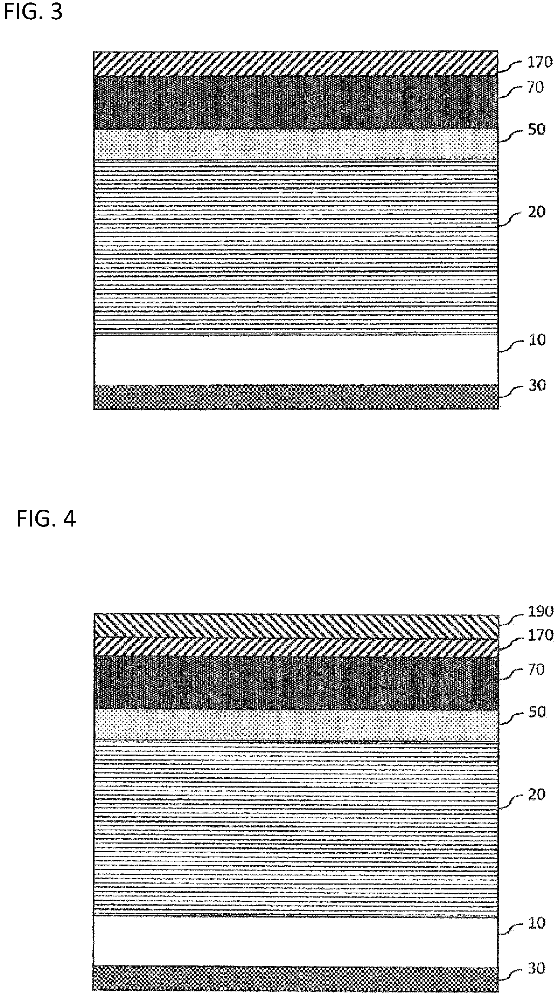

As illustrated in FIG. 1, a reflective photomask blank of the present embodiment has a multilayer reflective film 20 that is formed on one main surface (front surface) of a substrate 10 and reflects exposure light, a protective film 50, and an absorbing film 70, and may further have an etching mask film 170 (see FIGS. 3 and 4) that functions as an etching mask when the absorbing film 70 is processed. In addition, a back surface conductive film 30 may be provided on the other main surface of the substrate.

The reflective photomask blank is suitable as a material of a reflective photomask used in EUV lithography in which EUV light is used as exposure light. The EUV light used in the EUV lithography in which the EUV light is used as the exposure light has a wavelength of 13 nm to 14 nm, and is usually light having a wavelength of about 13.5 nm. The reflective photomask blank and the reflective photomask using the EUV light as the exposure light are also referred to as an EUV mask blank and an EUV mask, respectively.

The substrate 10 preferably has low thermal expansion characteristics for use in exposure to EUV light, and for example, is preferably made of a material having a thermal expansion coefficient within a range of $\pm\ 2 \times 10^{-8}/°C$, preferably within a range of $\pm\ 5 \times 10^{-9}/°C$. Examples of such a material include titania-doped quartz glass ($SiO_2$-$TiO_2$-based glass). In addition, it is preferable to use the substrate 10 whose surface is sufficiently planarized, and a surface roughness of the main surface of the substrate 10 is preferably 0.5 nm or less, more preferably 0.2 nm or less in RMS value. Such a surface roughness can be obtained by polishing the substrate 10 or the like. The substrate 10 preferably has a size in which a size of the main surface of the substrate 10 is 152 mm square and a thickness of the substrate 10 is 6.35 mm. The substrate 10 having such a size is a substrate referred to as a so-called 6025 substrate (substrate having a main surface size of 6 inch square and a thickness of 0.25 inch).

The multilayer reflective film 20 is a film that reflects the exposure light in the reflective photomask. The multilayer reflective film 20 is preferably provided in contact with the one main surface of the substrate 10, but another film such as a base film may be provided between the multilayer reflective film and the one main surface of the substrate 10. The multilayer reflective film 20 has a periodically laminated structure in which a high refractive index layer having a relatively high refractive index to the exposure light and a low refractive index layer having a relatively low refractive index to the exposure light are alternately laminated.

The high refractive index layer is preferably made of a material containing silicon (Si). The high refractive index layer may contain one or more additive elements selected from oxygen (O), nitrogen (N), carbon (C), boron (B), and hydrogen (H), and may include multiple layers of a layer containing the additive element and a layer not containing the additive element. A thickness of the high refractive index layer is preferably 3.5 nm or more, more preferably 4 nm or more, and preferably 4.9 nm or less, more preferably 4.4 nm or less.

The low refractive index layer is preferably made of a material containing molybdenum (Mo). The low refractive index layer can also be made of a material containing ruthenium (Ru). The low refractive index layer may contain one or more additive elements selected from oxygen (O), nitrogen (N), carbon (C), boron (B), and hydrogen (H), and may include multiple layers of a layer containing the additive element and a layer not containing the additive element. A thickness of the low refractive index layer is preferably 2.1 nm or more, more preferably 2.6 nm or more, and preferably 3.5 nm or less, more preferably 3 nm or less.

It is sufficient for the periodically laminated structure to include the high refractive index layer and the low refractive index layer, and to include one or more high refractive index layers and one or more low refractive index layers in one cycle. The number of layers included in the periodically laminated structure is two or more, and the periodically laminated structure can include, for example, one high refractive index layer and one low refractive index layer. In addition, two or more high refractive index layers having mutually different compositions (for example, different composition ratios or compositions that are different depending on the presence or absence of the additive element) may be included, and two or more low refractive index layers having different compositions (for example, different composition ratios or compositions that are different depending on the presence or absence of the additive element) may be included. In this case, the number of layers included in the periodically laminated structure is three or more, and may be four or more or five or more, but is preferably eight or less. The number of cycles is preferably 30 cycles or more, and preferably 50 cycles or less, more preferably 40 cycles or less. In a case where the low refractive index layer is made of the material containing ruthenium (Ru), a layer (uppermost layer) farthest from the substrate 10 having the periodically laminated structure is preferably the high refractive index layer.

A thickness of the multilayer reflective film 20 having the periodically laminated structure is adjusted according to an exposure wavelength and an incident angle of the exposure light, and is preferably 200 nm or more, more preferably 270 nm or more, and is preferably 400 nm or less, more preferably 290 nm or less.

Examples of a method for forming the multilayer reflective film 20 include a sputtering method in which power is supplied to a target, an atmospheric gas is converted into plasma (ionized) with the supplied power, and sputtering is performed, and an ion beam sputtering method in which a target is irradiated with an ion beam. Examples of the sputtering method include a DC sputtering method in which a DC voltage is applied to a target, and an RF sputtering method in which a radio frequency voltage is applied to a target. The sputtering method is a film forming method that utilizes a sputtering phenomenon of gas ions by applying a voltage to a target in a state where a sputtering gas is introduced into a chamber to ionize the gas and a sputtering phenomenon by gas ions is used. In particular, a magnetron sputtering method is advantageous in terms of productivity. The power applied to a target may be DC or RF, and the case of DC also includes pulse sputtering that inverts a negative bias applied to a target for a short time to prevent charge-up of the target.

The multilayer reflective film 20 can be formed, for example, by a sputtering method using a sputtering apparatus on which a plurality of targets can be mounted. Specifically, the multilayer reflective film 20 can be formed by using targets appropriately selected from a molybdenum (Mo) target for forming a layer containing molybdenum (Mo), a ruthenium (Ru) target for forming a layer containing ruthenium (Ru), a silicon (Si) target for forming a layer containing silicon (Si), and the like and using a rare gas such as a helium (He) gas, an argon (Ar) gas, a krypton (Kr) gas, or a xenon (Xe) gas as the sputtering gas.

In addition, in a case where sputtering is reactive sputtering using a reactive gas, it is sufficient to use, together with the rare gas, for example, a nitrogen-containing gas such as a nitrogen gas ($N_2$ gas) to form a film containing nitrogen (N), an oxygen-containing gas such as an oxygen ($O_2$) gas to form a film containing oxygen (O), a nitrogen oxide gas such as a nitrous oxide ($N_2O$) gas, a nitrogen monoxide (NO) gas, or a nitrogen dioxide ($NO_2$) gas to form to form a film containing nitrogen (N) and oxygen (O), a carbon oxide gas such as a carbon monoxide (CO) gas or a carbon dioxide ($CO_2$) gas to form a film containing carbon (C) and oxygen (O), a hydrogen-containing gas such as a hydrogen ($H_2$) gas to form a film containing hydrogen (H), and a hydrocarbon gas such as a methane ($CH_4$) gas to form a film containing carbon (C) and hydrogen (H).

Furthermore, a molybdenum (Mo) target added with boron (B) (a molybdenum boride (MoB) target), a silicon (Si) target added with boron (B) (a silicon boride (SiB) target), or the like can be used to form a layer containing boron (B).

The protective film 50 is also referred to as a capping film. The protective film 50 is a film for protecting the multilayer reflective film 20. The protective film 50 is usually provided in contact with the multilayer reflective film 20. The protective film 50 is made of a material containing ruthenium (Ru).

Examples of the material containing ruthenium (Ru) include a simple substance of ruthenium (Ru) and an alloy containing ruthenium (Ru) and a metal or a metalloid different from ruthenium (Ru). Examples of the metal or metalloid different from ruthenium (Ru) include niobium (Nb), rhenium (Re), zirconium (Zr), titanium (Ti), chromium (Cr), and silicon (Si). The content of the metal or metalloid different from ruthenium (Ru) in the protective film 50 is preferably 30 atom% or less, more preferably 20 atom% or less. A lower limit of the content of the metal or metalloid different from ruthenium (Ru) in the protective film 50 is not particularly limited, but is preferably 5 atom% or more, more preferably 10 atom% or more.

The protective film 50 may have a single-layer structure or a multilayer structure in which a plurality of layers having different compositions are combined, and the single layer or each layer constituting the plurality of layers may have an inclined composition structure in which the composition continuously changes in a thickness direction. In particular, one or both of a side close to the multilayer reflective film 20 (in the case of the multilayer structure, a layer close to the multilayer reflective film 20) and a side farthest from the multilayer reflective film 20 (in the case of the multilayer structure, a layer farthest from the multilayer reflective film 20) of the protective film 50 can be made of ruthenium (Ru) .

In addition, in a case where the protective film 50 has the multilayer structure or the inclined composition structure, it is preferable that the content of the metal or metalloid different from ruthenium (Ru) increases from the multilayer reflective film side toward the side far from the multilayer reflective film in a part or the whole of the protective film 50 in the thickness direction. In particular, in a case where niobium (Nb) is contained as the metal or metalloid different from ruthenium (Ru), the content of niobium (Nb) is preferably increased from the multilayer reflective film side toward the side far from the multilayer reflective film in a part or the whole of the protective film 50 in the thickness direction since it is effective to contain niobium (Nb) also in terms of improving resistance to dry etching using a gas including chlorine (Cl) and oxygen (O).

In the present embodiment, specific examples of the dry etching using the gas including chlorine (Cl) and oxygen (O) include dry etching using a gas including a chlorine ($Cl_2$) gas and an oxygen ($O_2$) gas. The gas including chlorine (Cl) and oxygen (O) may include rare gases such as a helium (He) gas, an argon (Ar) gas, a krypton (Kr) gas, and a xenon (Xe) gas.

A thickness of the protective film 50 is preferably 2 nm or more, more preferably 3 nm or more, and preferably 5 nm or less, more preferably 4 nm or less. A function of protecting the multilayer reflective film becomes insufficient in a case where the thickness of the protective film 50 is less than 2 nm, and a reflectance with respect to EUV light is reduced in a case where the thickness is more than 5 nm.

The protective film 50 can be formed by performing sputtering using a target appropriately selected from a ruthenium (Ru) target, a target of the metal or metalloid different from ruthenium (Ru), specifically, a niobium (Nb) target, a rhenium (Re) target, a zirconium (Zr) target, a titanium (Ti) target, a chromium (Cr) target, a silicon (Si) target, or a target obtained by mixing two or more selected from niobium (Nb), rhenium (Re), zirconium (Zr), titanium (Ti), chromium (Cr), and silicon (Si), and a target in which ruthenium (Ru) is mixed with one or more metals or metalloids different from ruthenium (Ru) and selected from niobium (Nb), rhenium (Re), zirconium (Zr), titanium (Ti), chromium (Cr), and silicon (Si), and using a rare gas such as a helium (He) gas, an argon (Ar) gas, a krypton (Kr) gas, or a xenon (Xe) gas as a sputtering gas. The sputtering is preferably magnetron sputtering.

After the formation of the multilayer reflective film 20 or the protective film 50, heat treatment may be performed, and it is possible to suppress variations in characteristics such as the reflectance with respect to EUV light in a case where heat is applied during formation of a mask pattern by performing the heat treatment. In general, the heat treatment is preferably performed at a temperature between 120°C and 150°C, and a temperature higher than 150°C is not preferable because the reflectance with respect to EUV light is reduced.

The heat treatment may be performed the formation of any one or both of the multilayer reflective film 20 and the protective film 50, but the number of times of the heat treatment is preferably small from the viewpoint of concern of defective adhesion, productivity, and the like, and it is preferable to perform the heat treatment after the formation of the protective film 50.

Meanwhile, in a case where the heat treatment is performed after the formation of the protective film 50, an oxide film is formed on the surface of the protective film 50 so that a reflectance with respect to pattern inspection light is reduced in some cases. In addition, even in a case where the heat treatment is not performed after the formation of the protective film 50, a surface layer of the protective film 50 is highly likely to be oxidized after pattern formation, and thus, it is necessary to set a reflectance of the absorbing film 70 with respect to the pattern inspection light to a reflectance premised on the oxidization of the protective film 50.

The absorbing film 70 may have a single-layer structure made of Ta and N and have a natural oxide layer formed by exposing the absorbing film 70 to the atmosphere after the formation of the absorbing film 70. After the formation of the absorbing film 70, heat treatment at 150°C for the purpose of adjusting film stress or the like may be performed, and an oxide film formed by the heat treatment may be present. At this time, the oxide film formed on a surface layer is preferably as thin as possible, and is 2 nm or less, more preferably 1 nm or less. In a case where the oxide film on the surface layer is formed to be thick, the oxide film has a slower etching rate than a layer that is not oxidized, which causes deterioration of a pattern shape, which is not preferable.

The absorbing film 70 preferably contains nitrogen between 30% and 60%, more preferably between 40% and 55%. In a case where the content of nitrogen is less than 30%, reflected light with respect to the pattern inspection light becomes too high, and reflectance contrast becomes low. On the other hand, in a case where the content of nitrogen is higher than 60%, there are problems that EUV light is hardly absorbed and a sheet resistance of the absorbing film 70 becomes too high, which is not preferable.

Note that contrast is defined as follows.

$$\mathrm{Contrast}\ (\%)\ =\ ((Rc)\ -\ (Ra))/(Rc\ +\ Ra))\ \times\ 100$$

Rc: Reflectance of protective film 50 with respect to inspection light
Ra: Reflectance of absorbing film 70 with respect to inspection light
The contrast with respect to the pattern inspection light is preferably high. Specifically, the contrast is preferably 20% or more, more preferably 25% or more. In a case where the contrast is 15% or less, there is a high possibility that an edge portion of the pattern cannot be detected or an abnormal site cannot be detected.

A film thickness of the absorbing film 70 including Ta is preferably between 50 nm and 80 nm, more preferably between 55 nm and 70 nm in total for all the layers. The sheet resistance of the absorbing film 70 is preferably $10^6\ \Omega/A$ or less, more preferably $10^5\ \Omega/A$ or less. A surface roughness Sq of the absorbing film 70 is preferably 0.8 nm or less, more preferably 0.6 nm or less. This is because a reflectance of an absorber film portion with respect to EUV light is not sufficiently reduced during mask creation, and contrast with an opening cannot be sufficiently taken when the absorbing film 70 formed using a single-layer film containing tantalum (Ta) and nitrogen (N) is thinner than 50 nm, and wafer transfer performance is deteriorated due to the influence of a three-dimensional effect during exposure when the absorbing film 70 is thicker than 80 nm.

The absorbing film 70 can be formed by sputtering, and the sputtering is preferably magnetron sputtering. The absorbing film 70 can be formed by using a tantalum (Ta) target or a target containing tantalum (Ta) and nitrogen (N) and performing sputtering using a rare gas such as a helium (He) gas, a neon (Ne) gas, an argon (Ar) gas, a krypton (Kr) gas, or a xenon (Xe) gas as a sputtering gas or reactive sputtering using a nitrogen ($N_2$) gas together with the rare gas.

As illustrated in FIG. 3, the etching mask film 170 having an etching characteristic different from that of the absorbing film 70 can be provided as the etching mask film 170 of the absorbing film 70 on a side of the absorbing film 70 far from the substrate 10. The etching mask film 170 is a film that functions as an etching mask during dry etching of the absorbing film 70. The etching mask film 170 is preferably provided in contact with the absorbing film 70. The etching mask film 170 may include a single layer or multiple layers. The etching mask film 170 is preferably a film containing Cr, and examples thereof include CrN, CrO, CrON, and CrCON. A thickness of the etching mask film 170 is not particularly limited, but is preferably 1 nm or more, more preferably 2 nm or more, still more preferably 5 nm or more, and preferably 20 nm or less, more preferably 10 nm or less since there is a possibility that the function as the etching mask is not achieved in a case where the thickness is too small, and there is a possibility that processing characteristics are deteriorated in a case where the thickness is too large.

The etching mask film 170 can be formed by sputtering. Specifically, the etching mask film 170 can be formed by using a target appropriately selected, according to a composition, from a chromium (Cr) target or a chromium (Cr) compound target (a target containing chromium (Cr) and oxygen (O), nitrogen (N), carbon (C), or the like) in a case where a material containing chromium (Cr) is used or from a tantalum (Ta) target and a tantalum (Ta) compound target (a target containing tantalum (Ta) and oxygen (O), nitrogen (N), carbon (C), boron (B), or the like) in a case where a material containing tantalum (Ta) is used and performing sputtering using a rare gas such as a helium (He) gas, an argon (Ar) gas, a krypton (Kr) gas, or a xenon (Xe) gas as a sputtering gas or reactive sputtering using a reactive gas such as an oxygen-containing gas, a nitrogen-containing gas, or a carbon-containing gas, specifically, an oxygen ($O_2$) gas, a nitrogen ($N_2$) gas, a nitrogen oxide ($N_2O$, NO, $NO_2$) gas, a carbon oxide (CO, $CO_2$) gas, a hydrogen ($H_2$) gas, a hydrocarbon gas (for example, methane $CH_4$) gas, or the like together with the rare gas. The sputtering is preferably magnetron sputtering.

On the other main surface (back surface) which is a surface opposite to the one main surface of the substrate 10, a conductive film (the back surface conductive film 30) used to electrostatically chuck the reflective photomask to an exposure apparatus (for example, an EUV scanner) may be provided, preferably in contact with the other main surface.

The back surface conductive film 30 preferably has a sheet resistance of 100 $\Omega$/A or less, and a material thereof is not particularly limited. Examples of the material of the back surface conductive film 30 include a material containing tantalum (Ta) or chromium (Cr). In addition, the material containing tantalum (Ta) may contain oxygen (O), nitrogen (N), carbon (C), boron (B), or the like, and the material containing chromium (Cr) may contain oxygen (O), nitrogen (N), carbon (C), or the like. Examples of the material containing tantalum (Ta) include tantalum (Ta) compounds such as a simple substance of Ta, TaO, TaN, TaON, TaC, TaCN, TaCO, TaCON, TaB, TaOB, TaNB, TaONB, TaCB, TaCNB, TaCOB, and TaCONB. Specific examples of the material containing chromium (Cr) include chromium (Cr) compounds such as a simple substance of Cr, CrO, CrN, CrON, CrC, CrCN, CrCO, and CrCON.

A thickness of the back surface conductive film 30 is not particularly limited as long as a function as an electrostatic chuck is achieved, but is usually about 20 nm to 300 nm. The thickness of the back surface conductive film 30 is preferably formed so as to be balanced in film stress with a film and a pattern of the film formed on the one main surface (front surface) side after formation as the reflective photomask, that is, after formation of the pattern of the absorbing film 70 (see FIG. 2). The back surface conductive film 30 may be formed before the multilayer reflective film 20 is formed or after all the films on the multilayer reflective film side of the substrate 10 are formed, or the back surface conductive film 30 may be formed after some films on the multilayer reflective film side of the substrate 10 are formed, and thereafter, the remaining films on the multilayer reflective film side of the substrate 10 are formed. The back surface conductive film 30 can be formed by, for example, a magnetron sputtering method.

As illustrated in FIG. 4, the reflective photomask blank may have a resist film 190 formed on the side farthest from the substrate 10. The resist film 190 is preferably an electron beam (EB) resist.

For example, a reflective photomask having the substrate 10, the multilayer reflective film 20 formed on the one main surface of the substrate 10, the protective film 50 formed in contact with the multilayer reflective film 20, and a pattern (absorbing film pattern) of the absorbing film 70 can be manufactured from the reflective photomask blank. In the reflective photomask, a transfer pattern is formed by a difference in reflectance between a portion where the absorbing film 70 is formed and a portion where the absorbing film 70 is not formed.

The reflective photomask can be manufactured by a method including:

a step of preparing the reflective photomask blank;
a step of forming the resist film 190 on the absorbing film 70 as necessary;
a step of forming a resist pattern from the resist film 190 on the absorbing film 70;
a step of etching the absorbing film 70 using the resist pattern as an etching mask to form the pattern of the absorbing film 70; and

a step of removing the resist pattern.

The absorbing film 70 made of a material containing tantalum (Ta) and nitrogen (N) can be etched by dry etching using a gas containing chlorine (Cl) or a gas containing fluorine (F).

Alternatively, the reflective photomask can be manufactured by a method including:

a step of preparing the reflective photomask blank;

forming the resist film 190 on the etching mask film 170 as necessary;

forming a resist pattern from the resist film 190 on the etching mask film 170;

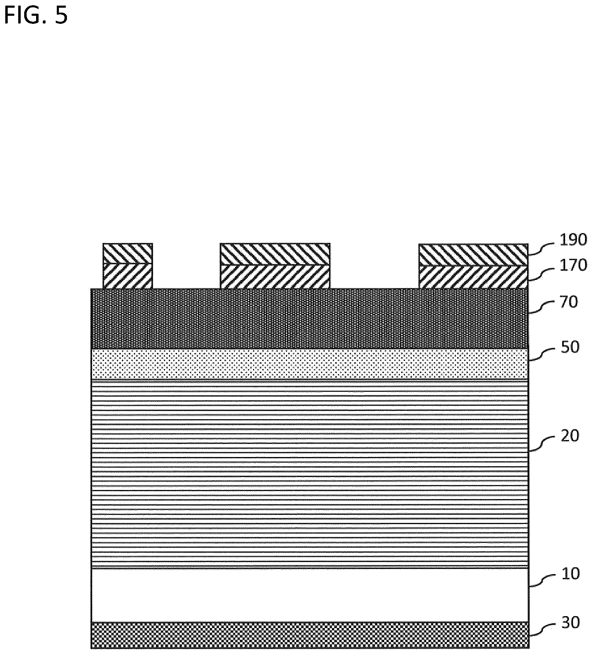

a step of etching the etching mask film 170 using the resist pattern as an etching mask to form a pattern of the etching mask film 170 (see FIG. 5);

a step of etching the absorbing film 70 using the pattern of the etching mask film 170 as an etching mask to form the pattern of the absorbing film 70 (see FIG. 2);

a step of removing the resist pattern; and

a step of removing the pattern of the etching mask film 170.

The etching mask film 170 can be a film containing chromium (Cr), the etching mask film 170 can be patterned by dry etching using a gas including chlorine (Cl) and oxygen (O) to form a pattern of the etching mask film 170, the absorbing film 70 can be patterned using the pattern of the etching mask film 170 as an etching mask, and then the etching mask film 170 can be removed by dry etching using a gas including chlorine (Cl) and oxygen (O).

Examples

Hereinafter, the present invention will be specifically described with reference to Examples and Comparative Examples, but the present invention is not limited to the following Examples.

Example 1

The multilayer reflective film 20 having a thickness of 284 nm was formed on a main surface of a low thermal expansion glass substrate ($SiO_2$-$TiO_2$-based glass substrate) having a size of 152 mm square and a thickness of 6.35 mm by DC pulse magnetron sputtering using a molybdenum (Mo) target and a silicon (Si) target while rotating the substrate 10 with both the targets facing the main surface of the substrate 10. Each of the targets was mounted on a sputtering apparatus that enables two targets to be mounted and can discharge both the targets one by one or at the same time, and the substrate 10 was placed.

First, power was applied to the silicon (Si) target while causing an argon (Ar) gas to flow into a chamber to form a silicon (Si) layer having a thickness of 4 nm, and the application of power to the silicon (Si) target was stopped. Next, power was applied to the molybdenum (Mo) target while causing an argon (Ar) gas to flow into the chamber to form a molybdenum (Mo) layer having a thickness of 3 nm, and the application of power to the molybdenum (Mo) target was stopped. An operation of forming these silicon (Si) layer and molybdenum (Mo) layer was set as one cycle, and this was repeated forty cycles to form a molybdenum (Mo) layer of the fortieth cycle, and then a silicon (Si) layer of 3 nm was finally formed by the above method, and a molybdenum (Mo) layer of 0.5 nm was further formed thereon, thereby forming the multilayer reflective film 20.

A target was mounted on another sputtering apparatus, and the substrate 10 on which the multilayer reflective film 20 was formed was placed via a transport path maintaining a vacuum state from the sputtering apparatus forming the multilayer reflective film 20 without being taken out into the atmosphere after the formation of the multilayer reflective film 20, Next, the protective film 50 was formed on the multilayer reflective film 20 by DC pulse magnetron sputtering using a ruthenium (Ru) target while rotating the substrate 10 with the target facing the main surface of the substrate 10. At this time, power was applied to the ruthenium (Ru) target while causing an argon (Ar) gas to flow into the chamber to form a film containing Ru and having a thickness of 3.0 nm.

Next, the substrate 10 on which the multilayer reflective film 20 and the protective film 50 were formed was subjected to heat treatment at 150°C for fifteen minutes in the air atmosphere by a hot plate type heater to oxidize a surface portion of the protective film 50.

A reflectance of a film obtained by the heat treatment at a wavelength of 193 nm to 248 nm was measured by an ultraviolet-visible near-infrared spectrophotometer (SolidSpec3700 manufactured by Shimadzu Corporation).

Next, the absorbing film 70 was formed on the heat-treated film by DC pulse magnetron sputtering using a tantalum (Ta) target while rotating the substrate 10 with the target facing the main surface of the substrate 10. At this time, power was applied to the tantalum (Ta) target while causing an argon (Ar) gas and a nitrogen (N) gas to flow into the chamber to form a TaN film having a thickness of 70 nm.

A reflectance of the obtained film at a wavelength of 193 nm to 248 nm was measured by the same ultraviolet-visible near-infrared spectrophotometer. When reflectance contrast was calculated from the reflectances before and after the absorbing film 70 was formed, the reflectance contrast was 27.4% and 30.6% at wavelengths of 193 nm and 248 nm, respectively, and sufficient contrast was obtained with respect to pattern inspection light.

Next, when a composition of the absorbing film 70 was measured by an X-ray photoelectron spectroscopy (XPS) device (K-Alpha manufactured by Thermo Fisher Scientific Inc.), with respect to a total of tantalum (Ta) and nitrogen (N), tantalum (Ta) was 57 atom%, and nitrogen (N) was 43 atom%. In this case, a surface oxide layer (having a thickness of 1 nm) was formed by natural oxidation in the air. An oxygen content of the surface oxide layer was 20 atom% with respect to a total of tantalum (Ta), nitrogen (N), and oxygen (O) on a side of the surface oxide layer farthest from the substrate 10.

Example 2

The multilayer reflective film 20 was formed in the same manner as in Example 1. On the multilayer reflective film 20, the protective film 50 was formed by DC pulse magnetron sputtering using a ruthenium (Ru) target and a niobium (Nb) target while rotating the substrate 10 with both the targets facing the main surface of the substrate 10.

Specifically, the respective targets were mounted on another sputtering apparatus that enables two targets to be mounted and can discharge both the targets one by one or at the same time, and after the formation of the multilayer reflective film 20, the substrate 10 on which the multilayer reflective film 20 was formed was placed via a transport path maintaining a vacuum state from the sputtering apparatus forming the multilayer reflective film 20 without being taken out into the atmosphere. Next, power was simultaneously applied to the ruthenium (Ru) target and the niobium (Nb) target while causing an argon (Ar) gas to flow into a chamber, whereby a film having a thickness of 3.9 nm and containing RuNb at a composition ratio of 88 atom% of ruthenium (Ru) and 12 atom% of niobium (Nb) was formed as the protective film 50.

Thereafter, heat treatment was performed at 150°C for fifteen minutes in the same manner as in Example 1, and thereafter, a reflectance at a wavelength of 193 nm to 248 nm was measured by the ultraviolet-visible near-infrared spectrophotometer.

Furthermore, as the absorbing film 70 on the protective film 50, the same film as that of Example 1, that is, the film containing 57 atom% of tantalum (Ta) and 43 atom% of nitrogen (N) with respect to the total of tantalum (Ta) and nitrogen (N) was formed. A reflectance at a wavelength of 193 nm to 248 nm was measured by the same ultraviolet-visible near-infrared spectrophotometer. When reflectance contrast was calculated from the reflectances before and after the absorbing film 70 was formed, the reflectance contrast was 24.9% and 26.0% at wavelengths of 193 nm and 248 nm, respectively, and sufficient contrast was obtained with respect to pattern inspection light.

Example 3

The multilayer reflective film 20 was formed in the same manner as in Example 1. On the multilayer reflective film 20, the protective film 50 was formed by DC pulse magnetron sputtering using a ruthenium (Ru) target and a niobium (Nb) target while rotating the substrate 10 with both the targets facing the main surface of the substrate 10. A film having a thickness of 3.6 nm and containing RuNb at a composition ratio of 85 atom% of ruthenium (Ru) and 15 atom% of niobium (Nb) was formed as the protective film 50 in the same manner as in Example 2 except for power applied to the respective targets when the power was simultaneously applied to the ruthenium (Ru) target and the niobium (Nb) target.

Next, heat treatment was performed at 150°C for fifteen minutes in the same manner as in Example 1, and thereafter, a reflectance at a wavelength of 193 nm to 248 nm was measured by the ultraviolet-visible near-infrared spectrophotometer.

Further, the absorbing film 70 was formed on the protective film 50. At this time, the absorbing film 70 having a thickness of 70 nm and containing 60 at% of tantalum (Ta) and 40 at% of nitrogen (N) was formed in the same manner as in Example 1 except that a ratio of an argon (Ar) gas to a nitrogen (N) gas to be introduced into a chamber was changed. A surface oxide layer (having a thickness of 1 nm) was formed by natural oxidation of the absorbing film 70 in the air. An oxygen content of the surface oxide layer was 22 atom% with respect to a total of tantalum (Ta), nitrogen (N), and oxygen (O) on a side of the surface oxide layer farthest from the substrate 10.

Thereafter, a reflectance at a wavelength of 193 nm to 248 nm was measured by the same ultraviolet-visible near-infrared spectrophotometer. When reflectance contrast was calculated from the reflectances before and after the absorbing film 70 was formed, the reflectance contrast was 22.1% and 27.3% at wavelengths of 193 nm and 248 nm, respectively, and sufficient contrast was obtained with respect to pattern inspection light.

Example 4

The multilayer reflective film 20 was formed in the same manner as in Example 1. On the multilayer reflective film 20, the protective film 50 was formed by DC pulse magnetron sputtering using a ruthenium (Ru) target and a niobium (Nb) target while rotating the substrate 10 with both the targets facing the main surface of the substrate 10. A film having a thickness of 3.9 nm and containing RuNb at a composition ratio of 82 atom% of ruthenium (Ru) and 18 atom% of niobium (Nb) was formed as the protective film 50 in the same manner as in Example 2 except for power applied to the respective targets when the power was simultaneously applied to the ruthenium (Ru) target and the niobium (Nb) target.

Next, heat treatment was performed at 150°C for fifteen minutes in the same manner as in Example 1, and thereafter, a reflectance at a wavelength of 193 nm to 248 nm was measured by the ultraviolet-visible near-infrared spectrophotometer.

Further, as the absorbing film 70 on the protective film 50, the absorbing film 70 having a thickness of 70 nm and containing 70 at% of tantalum (Ta) and 30 at% of nitrogen (N) was formed in the same manner as in Example 1 except that a ratio of an argon (Ar) gas to a nitrogen (N) gas to be introduced into a chamber was changed. A surface oxide layer (having a thickness of 1.3 nm) was formed by natural oxidation of the absorbing film 70 in the air. An oxygen content of the surface oxide layer was 30 atom% with respect to a total of tantalum (Ta), nitrogen (N), and oxygen (O) on a side of the surface oxide layer farthest from the substrate 10.

Thereafter, a reflectance at a wavelength of 193 nm to 248 nm was measured by the same ultraviolet-visible near-infrared spectrophotometer. When reflectance contrast was calculated from the reflectances before and after the absorbing film 70 was formed, the reflectance contrast was 21.1% and 28.0% at wavelengths of 193 nm and 248 nm, respectively, and sufficient contrast was obtained with respect to pattern inspection light.

Example 5

The multilayer reflective film 20 and the protective film 50 were formed in the same manner as in Example 3, heat treatment was performed at 150°C for fifteen minutes in the same manner as in Example 1, and thereafter, a reflectance at a wavelength of 193 nm to 248 nm was measured by the ultraviolet-visible near-infrared spectrophotometer.

As the absorbing film 70, a film similar to that of Example 1 except that a film thickness was 61 nm was formed (tantalum (Ta) was 57 atom% and nitrogen (N) was 43 atom% with respect to a total of tantalum (Ta) and nitrogen (N)), and thereafter, a reflectance at a wavelength of 193 nm to 248 nm was measured by the ultraviolet-visible near-infrared spectrophotometer. When reflectance contrast was calculated from the reflectances before and after the absorbing film 70 was formed, the reflectance contrast was 22.5% and 26.5% at wavelengths of 193 nm and 248 nm, respectively, and sufficient contrast was obtained with respect to pattern inspection light.

Comparative Example 1

The multilayer reflective film 20 and the protective film 50 were formed in the same manner as in Example 2, heat treatment was performed at 150°C for fifteen minutes in the same manner as in Example 1, and thereafter, a reflectance at a wavelength of 193 nm to 248 nm was measured by the ultraviolet-visible near-infrared spectrophotometer.

Next, the absorbing film 70 was formed, but, at the time of forming the absorbing film 70, only an argon (Ar) gas was introduced into a chamber without introducing a nitrogen (N) gas, and power was applied to a tantalum (Ta) target to form a Ta film having a thickness of 70 nm. A surface oxide layer (having a thickness of 1.5 nm) was formed by natural oxidation of the absorbing film 70 in the air. An oxygen content of the surface oxide layer was 50 atom% with respect to a total of tantalum (Ta), nitrogen (N), and oxygen (O) on a side of the surface oxide layer farthest from the substrate 10.

Thereafter, a reflectance at a wavelength of 193 nm to 248 nm was measured by the same ultraviolet-visible near-infrared spectrophotometer. When reflectance contrast was calculated from the reflectances before and after the absorbing film 70 was formed, the reflectance contrast was 8.2% and 17.1% at wavelengths of 193 nm and 248 nm, respectively, and sufficient contrast was not obtained with respect to pattern inspection light.

Comparative Example 2

The multilayer reflective film 20 and the protective film 50 were formed in the same manner as in Example 2, heat treatment was performed at 150°C for fifteen minutes in the same manner as in Example 1, and thereafter, a reflectance at a wavelength of 193 nm to 248 nm was measured by the ultraviolet-visible near-infrared spectrophotometer.

Next, the absorbing film 70 was formed. At the time of forming the absorbing film 70, the absorbing film 70 having a thickness of 70 nm and containing 80 atom% of tantalum (Ta) and 20 atom% of nitrogen (N) was formed in the same manner as in Example 1 except that a ratio of an argon (Ar) gas to a nitrogen (N) gas to be introduced into a chamber was changed. A surface oxide layer (having a thickness of 1.5 nm) was formed by natural oxidation of the absorbing film 70 in the air. An oxygen content of the surface oxide layer was 45 atom% with respect to a total of tantalum (Ta), nitrogen (N), and oxygen (O) on a side of the surface oxide layer farthest from the substrate 10.

Thereafter, a reflectance at a wavelength of 193 nm to 248 nm was measured by the same ultraviolet-visible near-infrared spectrophotometer. When reflectance contrast was calculated from the reflectances before and after the absorbing film 70 was formed, the reflectance contrast was 17.0% and 20.2% at wavelengths of 193 nm and 248 nm, respectively, and sufficient contrast was not obtained with respect to pattern inspection light.

Comparative Example 3

The multilayer reflective film 20 and the protective film 50 were formed in the same manner as in Example 2, heat treatment was performed at 150°C for fifteen minutes in the same manner as in Example 1, and thereafter, a reflectance at a wavelength of 193 nm to 248 nm was measured by the ultraviolet-visible near-infrared spectrophotometer.

Next, the absorbing film 70 was formed. At this time, in the same manner as in Comparative Example 2, a film having a thickness of 66 nm and containing 80 atom% of tantalum (Ta) and 20 atom% of nitrogen (N) was formed, and then, an argon (Ar) gas and oxygen (O) were introduced into the same chamber to form an oxide film having a thickness of 4 nm and containing 40 atom% of tantalum (Ta) and 60 atom% of oxygen (O), thereby forming the absorbing film 70 having a total film thickness of 70 nm.

Thereafter, a reflectance at a wavelength of 193 nm to 248 nm was measured by the same ultraviolet-visible near-infrared spectrophotometer. When reflectance contrast was calculated from the reflectances before and after the absorbing film 70 was formed, the reflectance contrast was 27.8% and 39.8% at wavelengths of 193 nm and 248 nm, respectively, and sufficient contrast was obtained with respect to pattern inspection light.

Meanwhile, since a portion of the oxide film is thick and has the degree of oxidation is high, an etching rate of an oxidized portion during processing is slower than that of an unoxidized portion, and there is a concern that a sectional shape of a pattern is deteriorated.

Reference Signs List

10　　Substrate
20　　Multilayer reflective film
50　　Protective film
70　　Absorbing film
170　　Etching mask film

**Claims**

1. A reflective photomask blank to be used as a material of a reflective photomask used in EUV lithography using EUV light as exposure light, the reflective photomask blank comprising:

   a substrate;
   a reflective multilayer film that is formed on one main surface of the substrate and reflects the exposure light;
   a protective film formed in contact with the reflective multilayer film; and
   an absorbing film that is formed on the protective film and absorbs the exposure light,
   wherein the protective film is formed using a film containing ruthenium (Ru),
   wherein the absorbing film is formed using a single-layer film containing tantalum (Ta) and nitrogen (N), and has a content of nitrogen of 30 atom% or more and less than 60 atom%, and
   wherein contrast between light reflected from a surface of the protective film and light reflected on a surface of the absorbing film with respect to light having a wavelength of 193 nm to 248 nm is 20% or more.

2. The reflective photomask blank according to claim 1, wherein a thickness of the absorbing film is between 50 nm and 80 nm.

3. The reflective photomask blank according to claim 1 or 2,
   wherein the protective film is made of ruthenium (Ru) or ruthenium (Ru) and niobium (Nb).

4. The reflective photomask blank according to any one of claims 1 to 3,
   wherein a thickness of the protective film is between 2 nm and 5 nm.

5. The reflective photomask blank according to any one of claims 1 to 4 further comprising an etching mask film containing Cr used as an etching mask when the absorbing film is processed.

6. A method for manufacturing the reflective photomask blank according to any one of claims 1 to 5 by using a sputtering method.

7. The method for manufacturing the reflective photomask blank according to claim 6,
   wherein an oxide layer with a thickness of 2 nm or less is formed by exposure to air or by a heat treatment at 150°C or less in air after the absorbing film is formed on a side surface separated from the substrate.

8. The method for manufacturing the reflective photomask blank according to claim 6 or 7,

   wherein the protective film is made of ruthenium (Ru) or ruthenium (Ru) and niobium (Nb), and
   wherein a heat treatment is performed at 150°C or lower in air after forming the protective film.

FIG. 1

FIG. 2

FIG. 3

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002246299 A
- JP 2002122981 A